# EUROPEAN PATENT APPLICATION

(11) **EP 4 768 951 A1**
(43) Date of publication of application: **01.07.2026**
(21) Application number: 25774855.8
(22) Date of filing: 17.02.2025
(51) Int. Cl.: G01R 31/385, G01R 19/00, G01R 19/10, G01R 19/12, H01M 10/052

(54) **BATTERY DIAGNOSIS APPARATUS AND OPERATION METHOD THEREOF**

(30) Priority: 19.03.2024 KR 20240037909
(71) Applicant: LG Energy Solution, Ltd., Seoul 07335 (KR)
(72) Inventor: CHOI, Jung Hwan, Daejeon 34122 (KR)
(74) Representative: Plasseraud IP
(86) International application number: PCT/KR2025/002298
(87) International publication number: WO 2025/198192

(57) **Abstract**

A battery diagnostic device according to an embodiment disclosed herein may include an interface configured to acquire a voltage value of each of battery cells and one or more controllers configured to calculate an average voltage value of the battery cell, calculate a cell voltage deviation of each of the battery cells based on the average voltage value, generate diagnostic data related to the cell voltage deviation according to the average voltage value for each of the battery cells, and diagnose a state of the battery cells based on the cell voltage deviation in a diagnostic section in which an amount of change in the cell voltage deviation of the diagnostic data corresponds to a specified condition.

## Description

### TECHNICAL FIELD

### CROSS-REFERENCE TO RELATED APPLICATIONS

This application claims priority from Korean Patent Application No. 10-2024-0037909, filed on March 19, 2024, the disclosure of which is incorporated by reference herein.

### TECHNICAL FIELD

Embodiments disclosed herein relates to a battery diagnostic device and a method of operating the same.

### BACKGROUND ART

In recent years, research and development for secondary batteries have been actively conducted. Here, the secondary battery is a battery capable of recharging and discharging, and in its meaning, includes all of the existing Ni/Cd battery, the Ni/MH battery, and the like and a recent lithium-ion battery. Among secondary batteries, the lithium-ion battery has the advantage of having a much higher energy density than the existing Ni/Cd battery, Ni/MH battery, and the like. In addition, since the lithium-ion battery may be manufactured to be small and lightweight, the lithium-ion battery is used as a power source for mobile devices, and in recent years, its scope of use expanded to include power sources for electric vehicles, attracting attention as a next-generation energy storage medium.

As the industrial fields utilizing batteries expand, a battery management system (BMS) that diagnoses the safety of batteries is also developing. The BMS may diagnose the state and/or performance of a battery utilizing various diagnostic algorithms and perform appropriate control according to the state of the battery.

### DISCLOSURE OF THE INVENTION

### TECHNICAL PROBLEM

In the related art, the state of a battery has been diagnosed based on voltage values within a specific voltage range (e.g., 2.5 V to 4.2 V). However, since the abnormality of the battery may be exhibited in mV units, there is a problem that it is difficult to diagnose the state of the battery using only the related art.

The technical problems of the embodiments disclosed herein are not limited to those mentioned above, and other objectives not mentioned will be clearly understood by those skilled in the art from the following descriptions.

### TECHNICAL SOLUTION

A battery diagnostic device according to an embodiment disclosed herein may include an interface configured to acquire a voltage value of each of battery cells and one or more controllers configured to calculate an average voltage value of the battery cells, calculate a cell voltage deviation of each of the battery cells based on the average voltage value, generate diagnostic data related to the cell voltage deviation according to the average voltage value for each of the battery cells, and diagnose a state of the battery cells based on the cell voltage deviation in a diagnostic section in which an amount of change in the cell voltage deviation of the diagnostic data corresponds to a specified condition.

In an embodiment, the controller may diagnose, as a low-voltage cell, a battery cell for which the cell voltage deviation is less than or equal to a first threshold value.

In an embodiment, the controller may diagnose a battery cell for which a slope value between cell voltage deviations according to at least two average voltage values is greater than or greater than a second threshold value as an abnormal capacity cell.

In an embodiment, the controller may diagnose a battery cell where a change in a slope of cell voltage deviations according to at least two average voltage values included in the diagnostic section is outside a threshold range as an abnormal behavior cell.

In an embodiment, the voltage value may be a voltage value acquired during a process of charging the battery cells.

In an embodiment, the battery cells may be included in one or more battery modules, and the controller may calculate an average voltage value for each battery module based on voltage values of the battery cells included in the same battery module and calculates the cell voltage deviation of each of the battery cells based on the average voltage value for each battery module.

In an embodiment, the specified condition may include a condition in which a change in an amount of change in the cell voltage deviation corresponds to linearity.

A method of operating a battery diagnostic device according to an embodiment disclosed herein may include acquiring a voltage value of each of battery cells, calculating an average voltage value of the battery cells, calculating a cell voltage deviation of each of the battery cells based on the average voltage value, generating diagnostic data related to the cell voltage deviation according to the average voltage value for each of the battery cells, and diagnosing a state of the battery cells based on the cell voltage deviation in a diagnostic section in which an amount of change in the cell voltage deviation of the diagnostic data corresponds to a specified condition.

In an embodiment, the diagnosing may include diagnosing, as a low-voltage cell, a battery cell for which the cell voltage deviation is less than or equal to a first threshold value.

In an embodiment, the diagnosing may include diagnosing a battery cell for which a slope value between cell voltage deviations according to at least two average voltage values is greater than or equal to a second threshold value as an abnormal capacity cell.

In an embodiment, the diagnosing may include diagnosing a battery cell for which a change in a slope of cell voltage deviations according to at least two average voltage values included in the diagnostic section is outside a threshold range as an abnormal behavior battery cell.

In an embodiment, the voltage value may be a voltage value acquired during a process of charging the battery cells.

In an embodiment, the battery cells may be included in one or more battery modules, and the calculating may include calculating an average voltage value for each battery module based on voltage values of the battery cells included in the same battery module and calculating the cell voltage deviation of each of the battery cells based on the average voltage value for each battery module.

In an embodiment, the specified condition may include a condition in which a change in an amount of change in the cell voltage deviation corresponds to linearity.

### ADVANTAGEOUS EFFECTS

A battery diagnostic device and a method of operating the same according to various embodiments disclosed herein can acquire voltage values of battery cells, calculate an average voltage value thereof, and diagnose the state of the battery cells through a cell voltage deviation (unit: mV), which is a difference between the voltage value of each battery cell and the average voltage value.

The effects of the battery diagnostic device and the method of operating the same according to the disclosure herein are not limited to the effects mentioned above, and other effects not mentioned will be clearly understood by those skilled in the art according to the disclosure herein.

### BRIEF DESCRIPTION OF THE DRAWINGS

FIG. 1 is a block diagram of a battery diagnostic device included in a battery pack according to an embodiment disclosed herein.
FIG. 2 illustrates a battery diagnostic device included in an external server according to an embodiment disclosed herein.
FIG. 3 illustrates diagnostic data according to an embodiment disclosed herein.
FIGS. 4a and 4b illustrate diagnostic data of a low-voltage cell according to an embodiment disclosed herein.
FIGS. 5a and 5b illustrate diagnostic data of an abnormal capacity cell according to an embodiment disclosed herein.
FIG. 6 illustrates diagnostic data of an abnormal behavior cell according to an embodiment disclosed herein.
FIG. 7 is a flowchart showing a method of operating a battery diagnostic device according to an embodiment disclosed herein.
FIG. 8 illustrates a computing system for executing operations of the battery diagnostic device according to an embodiment disclosed herein.

With respect to the description of the drawings, the same or similar reference signs may be used for the same or similar elements.

### MODE FOR CARRYING OUT THE INVENTION

Hereinafter, embodiments of the present invention will be described with reference to the accompanying drawings. However, this is not intended to limit the present disclosure to the specific embodiments, and it is to be construed to include various modifications, equivalents, and/or alternatives of embodiments of the present disclosure.

It should be appreciated that embodiments of the present disclosure and the terms used therein are not intended to limit the technological features set forth herein to a particular embodiment and include various changes, equivalents, or replacements in corresponding embodiments. With regard to the description of the drawings, similar or related reference numerals may be used to refer to similar or related elements. It is to be understood that a singular form of a noun corresponding to an item may include one or more of the things, unless the relevant context clearly indicates otherwise.

As used herein, each of phrases such as "A or B," "at least one of A and B," "at least one of A or B," "A, B, or C," "at least one of A, B, and C," and "at least one of A, B, or C," may include any one of, or all possible combinations of the items enumerated together in a corresponding one of the phrases. Terms such as "1st" and "2nd," "first," "second," "A." "B," "(a)," or "(b)" may be used to simply distinguish a corresponding component from another, and do not limit the components in other aspects (e.g., importance or order) unless specifically stated otherwise.

In the present specification, it is to be understood that if an element (e.g., a first element) is referred to, with or without the term "operatively" or "communicatively," as "connected to," "coupled to," or "in contact with" another element (e.g., a second element), it means that the element may be connected to the other element directly (e.g., by wire or wirelessly) or indirectly (e.g., via a third element).

A method according to various embodiments disclosed herein may be included and provided in a computer program product. The computer program product may be traded as a product between a seller and a buyer. The computer program product may be distributed in the form of a machine-readable storage medium (e.g., a compact disc read only memory and CD-ROM), or be distributed (e.g., downloaded or uploaded) online via an application store, or between two user devices directly. If distributed online, at least part of the computer program product may be temporarily generated or at least temporarily stored in the machine-readable storage medium, such as memory of the manufacturer's server, a server of the application store, or a relay server.

According to embodiments disclosed herein, each component (e.g., a module or a program) of the above-described components may include a single entity or multiple entities, and some of the plurality of entities may be disposed separately from other components. According to embodiments disclosed herein, one or more components or operations of the above-described components may be omitted, or one or more other components or operations may be added. Alternatively or additionally, a plurality of components (e.g., modules or programs) may be integrated into a single component. In such a case, the integrated component may still perform one or more functions of each of the plurality of components in the same or similar manner as those performed by a corresponding one of the plurality of components before the integration. According to embodiments disclosed herein, operations performed by the module, the program, or another component may be carried out sequentially, in parallel, repeatedly, or heuristically, or one or more of the operations may be executed in a different order or omitted, or one or more other operations may be added.

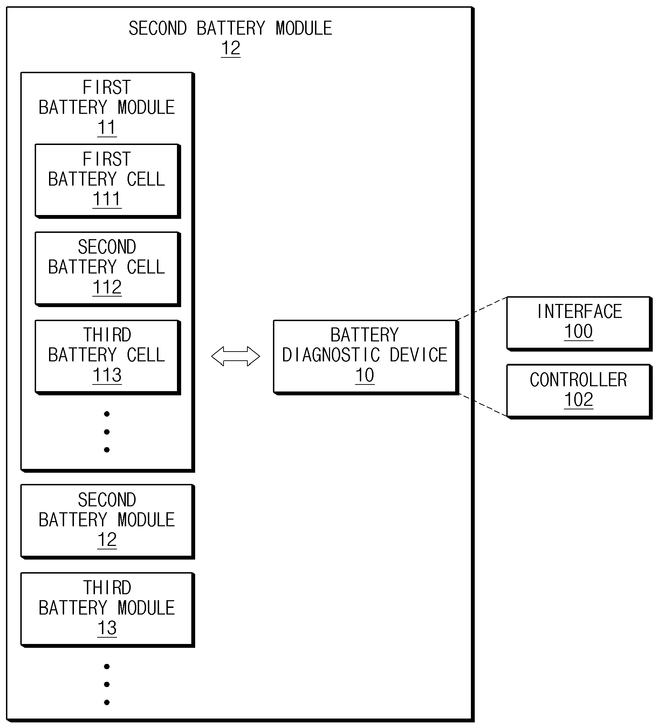

FIG. 1 is a block diagram of a battery diagnostic device included in a battery pack according to an embodiment disclosed herein.

Referring to FIG. 1, the battery diagnostic device 10 may acquire a voltage value of each of battery cells included in a battery pack 1.

The battery pack 1 may include the battery diagnostic device 10 and battery modules 11, 12, and 13. In FIG. 1, three battery modules are illustrated, but this is only for convenience of description, and the battery pack 1 may include one or more battery modules. In addition, in FIG. 1, only the battery cells 111, 112, and 113 included in a first battery module 11 are illustrated, but this is only for convenience of description, and a second battery module 12 and a third battery module 13 may also include a plurality of battery cells. In addition, although in FIG. 1, the number of battery cells 111, 112, and 113 included in the first battery module 11 is illustrated as three, the number is not limited thereto, and each of the battery cells 111, 112, and 113 may be configured to include n (n is a natural number greater than or equal to 2) battery cells.

According to various embodiments, when the battery pack 1 has a cell-to-pack (CTP) structure, the battery pack 1 may be configured to include a plurality of battery cells (e.g., drawing symbols 111, 112, and 113) without distinction between the battery modules 11, 12, and 13.

According to the embodiment, the battery cells 111, 112, and 113 may be a lithium-ion (Li-ion) battery, a lithium-ion polymer (Li-ion polymer) battery, a nickel-cadmium (Ni-Cd) battery, a nickel-metal hydride (Ni-MH) battery, a lithium iron phosphate (LFP) battery, a nickel-cobalt-manganese (NCM) battery, and the like, but are not limited thereto.

The battery diagnostic device 10 may calculate an average voltage value of the battery cells (e.g., 111, 112, and 113). For example, the battery diagnostic device 10 may calculate the average voltage value of the battery cells based on the voltage value of each of the battery cells acquired at the same time. Here, the average voltage value may be a value obtained by dividing the total sum of the voltage values of the battery cells by the number of battery cells.

The battery diagnostic device 10 may calculate a cell voltage deviation of each of the battery cells based on the average voltage value. Here, the cell voltage deviation may be a difference between the voltage value of each of the battery cells and the average voltage value.

The battery diagnostic device 10 may generate diagnostic data related to the cell voltage deviation according to the average voltage value for each of the battery cells. According to the embodiment, the diagnostic data may include a graph showing cell voltage deviations according to the average voltage value in two-dimensional coordinates.

The battery diagnostic device 10 may diagnose the state of battery cells based on diagnostic data. For example, the battery diagnostic device 10 may diagnose low voltage, abnormal capacity, and/or abnormal behavior of each of the battery cells based on the diagnostic data.

According to various embodiments, the battery diagnostic device 10 may diagnose the state of the battery cells 111, 112, and 113 included in the first battery module 11, the battery cells 111, 112, and 113 included in the second battery module 12, and the battery cells included in the third battery module 13, as well as the state of all battery cells included in the battery pack 1.

Hereinafter, a method in which a battery diagnostic device 10 diagnoses the state of the battery cells based on operations performed in each of the components 100 and 102 included in the battery diagnostic device 10 is described.

The battery diagnostic device 10 may include an interface 100 and one or more controllers 102. In FIG. 1, a single controller 102 is illustrated, but this is only for convenience of description and is not limited thereto, and the battery diagnostic device 10 may include a plurality of controllers that perform all or part of the operations performed in the controller 102. According to the embodiment, the battery diagnostic device 10 illustrated in FIG. 1 may further include at least one component (e.g., a display, an input device, or an output device) other than the components illustrated in FIG. 1.

The interface 100 may acquire a voltage value of each battery cell. The interface 100 may acquire a voltage value of each of all battery cells included in the battery pack 1. The interface 100 may acquire the voltage values during a process of charging battery cells. The interface 100 may acquire the voltage values during the process of charging battery cells with a constant current. The interface 100 may acquire a voltage value measured for each of the battery cells for each charging cycle.

According to various embodiments, the interface 100 may include various interface circuits for acquiring signals, information, and/or data, such as sensors, communication circuits, or the like.

The controller 102 may calculate an average voltage value of the battery cells. The controller 102 may calculate the average voltage value of the battery cells at every specified time. The controller 102 may calculate the average voltage value by dividing the total sum of the voltage values of the battery cells by the number of battery cells.

In an embodiment, the controller 102 may calculate the average voltage value for each battery module. The controller 102 may calculate the average voltage value for each battery module based on the voltage values of the battery cells included in the same battery module. For example, the controller 102 may calculate the average voltage value of the first battery module 11 by dividing the total sum of the voltage values of the battery cells 111, 112, and 113 included in the first battery module 11 by the number of battery cells 111, 112, and 113.

In addition, the controller 102 may calculate the average voltage value of the battery cells included in each of the second battery module 12 and the third battery module 13 using a method of calculating the average voltage value of the first battery module 11.

According to embodiments, the controller 102 may reduce errors occurring between the battery modules by calculating the average voltage value for each battery module by considering characteristics of each battery module (e.g., a scale error, an offset error, and noise).

Hereinafter, for convenience of description, a description is given assuming that the controller 102 diagnoses the state of the battery cells 111, 112, and 113 included in the first battery module 11, and a description is given assuming that the average voltage value is an average voltage value of the battery cells 111, 112, and 113 included in the first battery module 11.

The controller 102 may calculate the cell voltage deviation of each of the battery cells 111, 112, and 113 based on the average voltage value. Here, the cell voltage deviation may be the difference between the voltage value of each of the battery cells 111, 112, and 113 and the average voltage value.

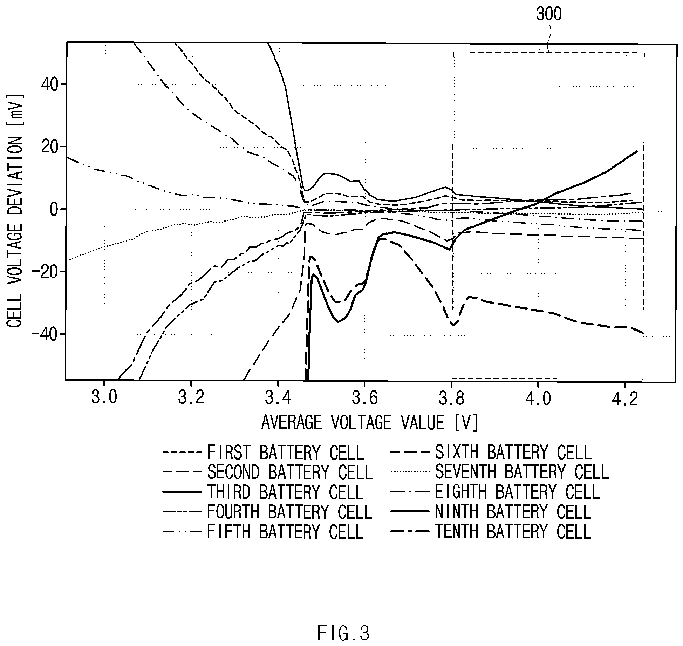

The controller 102 may generate diagnostic data related to the cell voltage deviation according to the average voltage value for each of the battery cells 111, 112, and 113. Here, the diagnostic data may include a graph showing cell voltage deviations according to the average voltage value on two-dimensional coordinates. Specific details regarding the diagnostic data are described below with reference to FIG. 3.

The controller 102 may diagnose the state of battery cells 111, 112, and 113 based on the cell voltage deviation in a diagnostic section in which the amount of change in the cell voltage deviation of the diagnostic data corresponds to a specified condition. According to embodiments, the specified condition may include a condition under which a change in the amount of change in the cell voltage deviation corresponds to linearity. Specific details regarding the diagnostic section according to the specified condition are described below with reference to FIG. 3.

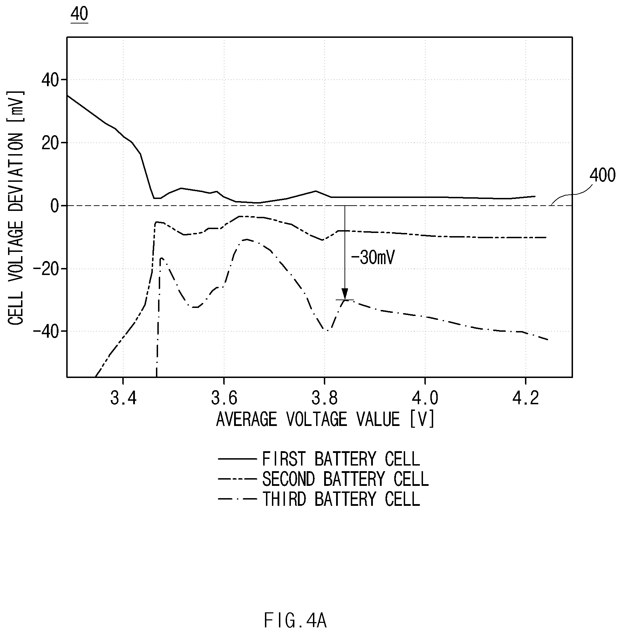

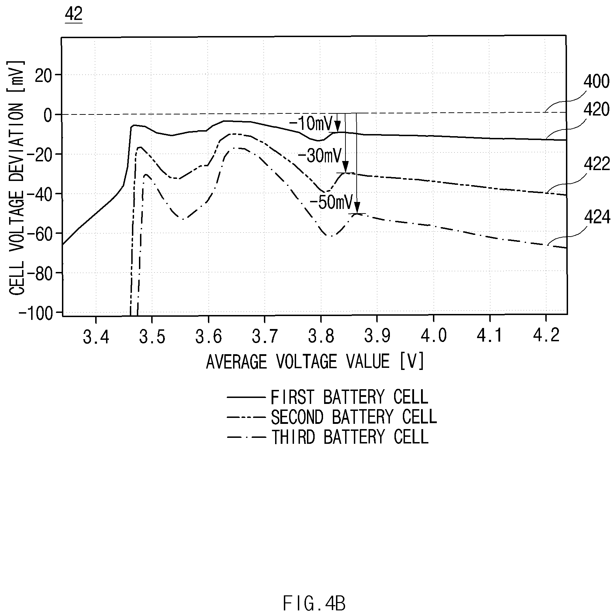

In an embodiment, the controller 102 may diagnose, as a low-voltage cell, a battery cell for which the cell voltage deviation is less than or equal to a first threshold value. The controller 102 may diagnose, as the low-voltage cell, a battery cell for which the cell voltage deviation in the diagnostic section is less than or equal to the first threshold value. Specific details regarding the first threshold value are described below with reference to FIGS. 4a and 4b.

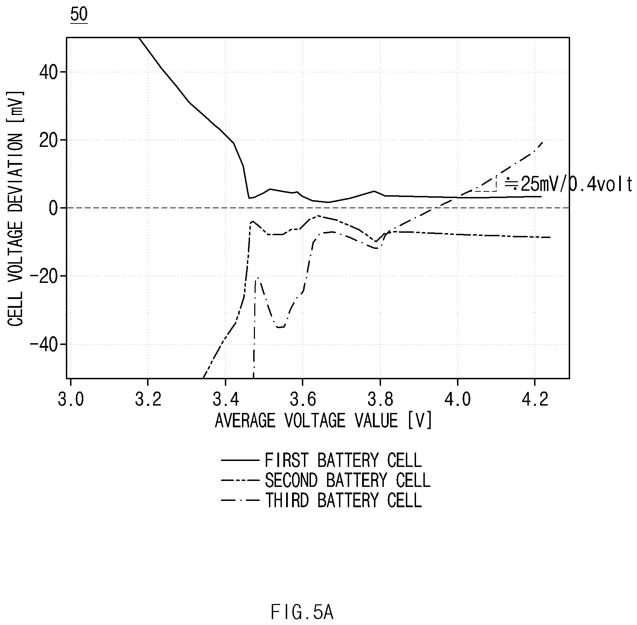

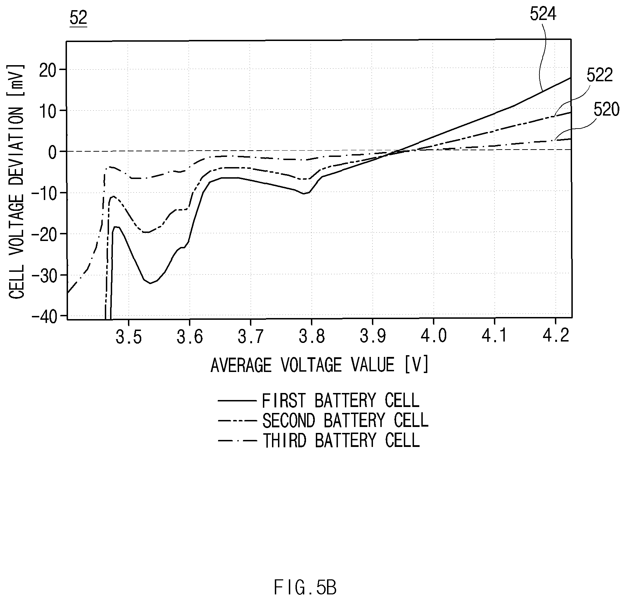

In an embodiment, the controller 102 may diagnose a battery cell for which a slope value between cell voltage deviations according to at least two average voltage values is less than or equal to a second threshold value as an abnormal capacity cell. The controller 102 may diagnose a battery cell for which a slope value between cell voltage deviations according to at least two average voltage values in the diagnostic section is less than or equal to the second threshold value as the abnormal capacity cell. Specific details regarding the second threshold value are described below with reference to FIGS. 5a and 5b.

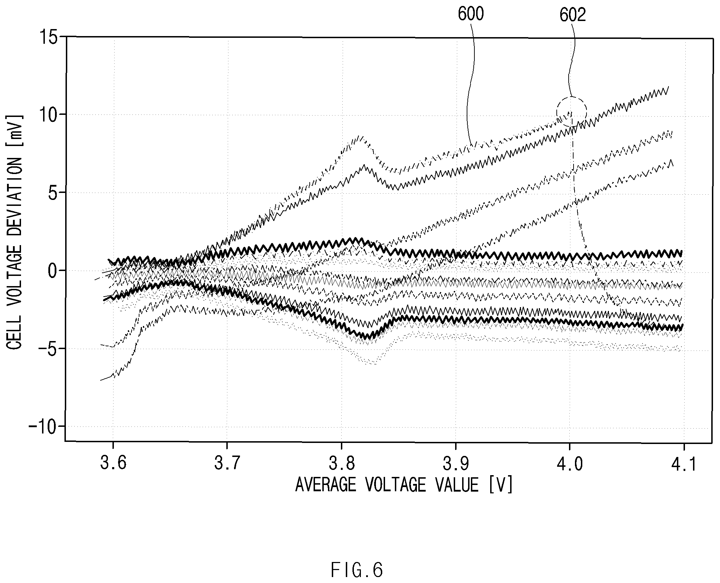

In an embodiment, the controller 102 may diagnose a battery cell for which a change in a slope of cell voltage deviations according to at least two average voltage values included in the diagnostic section is outside a threshold range as an abnormal behavior cell. Specific details regarding the threshold range are described below with reference to FIG. 6.

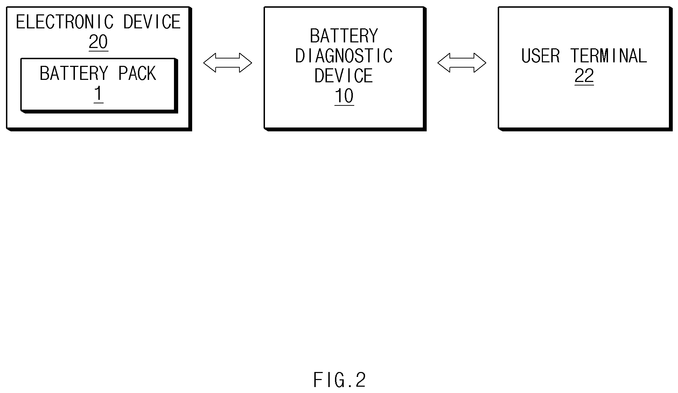

In the above, the description has been given assuming that the battery diagnostic device 10 included in the battery pack 1 is a device that diagnoses the state of the battery cells 111, 112, and 113, but the battery diagnostic device 10 may be included in a BMS that may diagnose the battery cells included in the battery pack 1, and operations performed in the battery diagnostic device 10 may be performed in the BMS. In addition, the battery diagnostic device 10 to be described in FIG. 2 may be included in a server, a cloud, or a charger capable of diagnosing battery cells outside the battery pack 1, and operations performed in the battery diagnostic device 10 may be performed in the external server or charger.

FIG. 2 illustrates a battery diagnostic device included in an external server according to an embodiment disclosed herein.

Referring to FIG. 2, the battery diagnostic device 10 may be connected to each of an electronic device 20 and a user terminal 22 via wires and/or wirelessly.

The connection between the battery diagnostic device 10 and the electronic device 20 may be a communication connection through a wired and/or wireless network. In an embodiment, the wired network may be based on local area network (LAN) communications, or power line communications. In an embodiment, the wireless network may be based on a short-range communication network (e.g., Bluetooth, wireless fidelity (WiFi), or infrared data association (IrDA)), or a long-range communication network (e.g., a cellular network, a 4G network, a 5G network). In an embodiment, the electronic device 20 may include a battery pack 1. The battery diagnostic device 10 may receive voltage values of battery cells measured by a BMS (not shown) included in the battery pack 1 through the wired and/or wireless network.

In an embodiment, the connection between the battery diagnostic device 10 and the electronic device 20 may be a connection through a device-to-device communication method (e.g., bus, general purpose input and output (GPIO), serial peripheral interface (SPI), or mobile industry processor interface (MIPI)).

In an embodiment, the electronic device 20 may be a mobile device (e.g., a mobile phone, a laptop computer, a smartphone, or a smart pad), an electric vehicle (e.g., an electric vehicle (EV), a hybrid EV (HEV), a plug-in HEV (PHEV), a fuel cell EV (FCEV)), an energy storage system (ESS), or a battery swapping system (BSS).

The connection between the battery diagnostic device 10 and the user terminal 22 may be a communication connection through the wired and/or wireless network. The battery diagnostic device 10 may transmit diagnostic results of battery cells to the user terminal 22 through the wired and/or wireless network. In an embodiment, the user terminal 22 may be a device that receives and analyzes the diagnostic results performed by the battery diagnostic device 10, and may be a mobile device (e.g., a mobile phone, a laptop computer, a smartphone, or a smart pad) or a personal computer (PC).

FIG. 3 illustrates diagnostic data according to an embodiment disclosed herein.

Referring to FIG. 3, the battery diagnostic device 10 may generate diagnostic data of battery cells (e.g., the first battery cell to the tenth battery cell) included in the first battery module. For example, the diagnostic data may be a graph showing a cell voltage deviation (y-axis) of each of the battery cells according to an average voltage value (x-axis) of the battery cells based on voltage values measured at the same time for the battery cells included in the first battery module. The diagnostic data may be generated for each of the battery cells included in the first battery module and may include all pieces of diagnostic data for each of the battery cells.

The battery diagnostic device 10 may select a diagnostic section 300 in which the amount of change in a cell voltage deviation of the diagnostic data corresponds to a specified condition. The diagnostic section 300 may be a section in which a change in the amount of change in the cell voltage deviation of each battery cell corresponds to linearity. The diagnostic section 300 illustrated in FIG. 3 may refer to a section of 3.8 V or higher, and it can be confirmed that in this section, for in a lithium ion battery, the change in the amount of change in the cell voltage deviation is close to a linear one with a constant slope. However, the diagnostic section 300 may differ depending on the material/type of the battery. The battery diagnostic device 10 may prevent errors occurring due to sections in which the change in the amount of change in the cell voltage deviation is irregular by selecting the diagnostic section 300 as a section in which the change in the amount of change in the cell voltage deviation corresponds to linearity.

FIGS. 4a and 4b illustrate diagnostic data of a low-voltage cell according to an embodiment disclosed herein.

Referring to FIG. 4a, the battery diagnostic device 10 may generate diagnostic data 40 of the first battery module. Referring to the diagnostic data 40 of the first battery module, the battery diagnostic device 10 may diagnose the state of battery cells based on a reference line 400. Here, the reference line 400 may refer to a line where the voltage value of the battery cell and the average voltage value match. In the case of a battery cell with a large difference between the reference line 400 and the cell voltage deviation, the cell may be a cell that has a high probability of exhibiting occurrence of an abnormality compared to the average. For example, the battery diagnostic device 10 may diagnose, as an abnormal low-voltage battery cell, a battery cell for which the voltage deviation from the reference line 400 is less than or equal to a first threshold value (e.g., 30 mV). Here, the first threshold value may be set based on an average of cell voltage deviations of battery cells corresponding to abnormal low-voltages through experiments. For example, in the case of a third battery cell, since the cell voltage deviation in the diagnostic section (e.g., the section of 3.8 V to 4.0 V) is less than or equal to the first threshold value, the third battery cell may be diagnosed as an abnormal low-voltage cell. When the cell voltage deviation of the third battery cell is less than or equal to -30 mV from the reference line in the diagnostic section, the third battery cell may be diagnosed as a low-voltage cell with approximately 3% of battery capacity leakage. Meanwhile, since the cell voltage deviation of a first battery cell is greater than or equal to the reference line 400, the battery diagnostic device 10 may diagnose the first battery cell as a normal-voltage cell, and since the cell voltage deviation of a second battery cell is greater than or equal to the first threshold value (e.g., -30 mV), the battery diagnostic device 10 may diagnose the second battery cell as a normal-voltage cell.

Referring to FIGS. 4a and 4b, the battery diagnostic device 10 may extract diagnostic data 42 of the third battery cell from the diagnostic data 40 of the first battery module to accurately diagnose the third battery cell. The diagnostic data 42 of the third battery cell may include three graphs 420, 422, and 424 according to the charging cycles for the third battery cell.

Referring to a first graph 420 according to a first cycle, it may be confirmed that the cell voltage deviation in the diagnostic section (e.g., section of 3.8 V to 4.0 V) of the third battery module in the first cycle is greater than or equal to the first threshold value (-30 mV). However, referring to a second graph 422 according to a second cycle and a third graph 424 according to a third cycle, it may be confirmed that the abnormal low voltage of the third battery cell worsens as the number of charging cycles increases. In this case, the battery diagnostic device 10 may diagnose that the third battery cell exhibits an abnormal low voltage from the second cycle through the second graph 422 of the third battery cell.

FIGS. 5a and 5b illustrate diagnostic data of an abnormal capacity cell according to an embodiment disclosed herein.

Referring to FIG. 5a, the battery diagnostic device 10 may generate diagnostic data 50 of the first battery module. Referring to the diagnostic data 50 of the first battery module, the battery diagnostic device 10 may diagnose the state of the battery cells based on a slope value between cell voltage deviations according to at least two average voltage values. The battery diagnostic device 10 may diagnose the state of battery cells based on the slope value in a diagnostic section (e.g., 3.8 V to 4.2 V). The battery diagnostic device 10 may diagnose the state of battery cells based on whether the slope value in the diagnostic section (e.g., 3.8 V to 4.2 V) is greater than or equal to a second threshold value (e.g., 30 mV/volt). Here, the second threshold value may be set based on the average of the cell voltage deviations of battery cells corresponding to the abnormal capacity through experiments.

The battery diagnostic device 10 may confirm that the slope value for the third battery cell is 62.5 mV/volt (25 mV/0.4 volt) in the diagnostic section, and the battery diagnostic device 10 may diagnose the third battery cell as an abnormal capacity cell. On the other hand, since slope values of the first battery cell and the second battery cell in the diagnostic section are close to 0 and correspond to values that are less than the second threshold value, the battery diagnostic device 10 may diagnose the first battery cell and the second battery cell as normal capacity cells.

Referring to FIGS. 5a and 5b, the battery diagnostic device 10 may extract diagnostic data 52 of the third battery cell from the diagnostic data 50 of the first battery module to accurately diagnose the third battery cell. The diagnostic data 52 of the third battery cell may include three graphs 520, 522, and 524 according to the charging cycles for the third battery cell.

Referring to a first graph 520 according to a first cycle to a third graph 524 according to a third cycle, it may be confirmed that the slope value of the third battery increases as the number of charging cycles increases, which may mean that the abnormal capacity of the third battery cell worsens. In this case, the battery diagnostic device 10 may diagnose the third battery cell as the abnormal capacity cell.

FIG. 6 illustrates diagnostic data of an abnormal behavior cell according to an embodiment disclosed herein.

Referring to FIG. 6, the diagnostic data of the abnormal behavior cell may include graphs according to a plurality of charging cycles (a first cycle to a fourteenth cycle) for a battery cell showing an abnormal behavior among battery cells to be diagnosed. In FIG. 6, a description is given under the assumption that the abnormal behavior cell is the third battery cell included in the first battery module described in FIG. 5. Here, the diagnostic data of the abnormal behavior cell may refer to diagnostic data extracted for precise diagnosis of the third battery cell suspected of having an abnormal behavior from diagnostic data of a plurality of battery cells.

The battery diagnostic device 10 may diagnose the third battery cell as the abnormal behavior cell based on whether a slope of cell voltage deviations according to at least two average voltage values included in a diagnostic section is outside a threshold range based on the diagnostic data of the abnormal behavior cell. Here, the threshold range may be set based on the average of cell voltage deviations of battery cells corresponding to an abnormal behavior through experiments.

Referring to a graph 600 in the fourteenth cycle included in the diagnostic data of the abnormal behavior cell, it may be confirmed that a pole 602 occurs in a section in which the average voltage value is around 4.0 V in a diagnostic region (e.g., 3.8 V or higher) of the third battery cell. The pole 602 is a section in which the cell voltage deviation of the third battery cell rapidly changes, and may be a section in which an abnormal behavior in which a slope change rapidly occurs exhibits. In this case, the battery diagnostic device 10 may diagnose that the third battery cell exhibits the abnormal behavior from the fourteenth cycle.

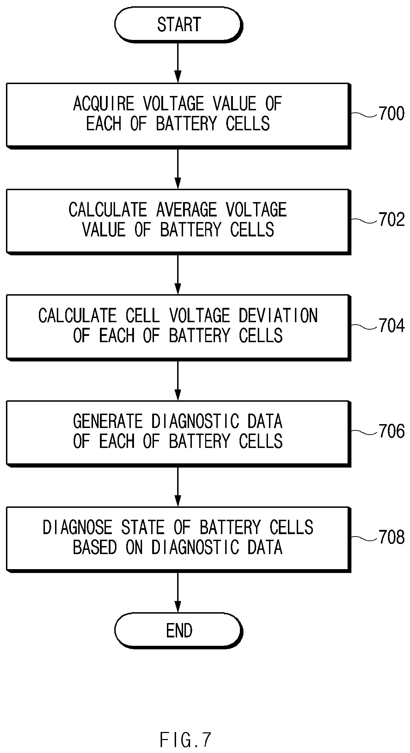

FIG. 7 is a flowchart showing a method of operating a battery diagnostic device according to an embodiment disclosed herein.

Referring to FIG. 7, in operation 700, the battery diagnostic device 10 may acquire a voltage value of each battery cell. The battery diagnostic device 10 may acquire the voltage values in a process of charging battery cells. The battery diagnostic device 10 may acquire the voltage values during a process of charging battery cells with a constant current. The battery diagnostic device 10 may acquire a voltage value measured for each of the battery cells for each charging cycle.

In operation 702, the battery diagnostic device 10 may calculate an average voltage value of the battery cells. The battery diagnostic device 10 may calculate the average voltage value of the battery cells at every specified time. The battery diagnostic device 10 may calculate the average voltage value by dividing the total sum of voltage values of the battery cells by the number of battery cells.

In an embodiment, the battery diagnostic device 10 may calculate the average voltage value for each battery module. The battery diagnostic device 10 may calculate the average voltage value for each battery module based on the voltage values of the battery cells included in the same battery module.

In operation 704, the battery diagnostic device 10 may calculate a cell voltage deviation of each of the battery cells based on the average voltage value.

In operation 706, the battery diagnostic device 10 may generate diagnostic data related to the cell voltage deviation according to the average voltage value for each of the battery cells.

In operation 708, the battery diagnostic device 10 may diagnose the state of battery cells based on diagnostic data. The battery diagnostic device 10 may diagnose the state of the battery cells based on the cell voltage deviation in a diagnostic section in which a change in the amount of change in the cell voltage deviation of the diagnostic data corresponds to a specified condition.

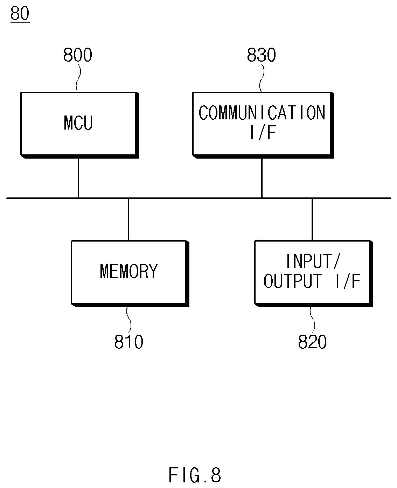

FIG. 8 illustrates a computing system for executing operations of the battery diagnostic device according to an embodiment disclosed herein.

Referring to FIG. 8, a computing system 80 according to an embodiment disclosed herein may include a microcontroller unit (MCU) 800, a memory 810, an input/output interface (I/F) 820, and a communication I/F 830.

The MCU 800 may be a processor that executes various programs (e.g., a battery diagnosis program) stored in the memory 810, processes various data from the programs, and performs functions of the battery diagnostic device 10 shown in FIGS. 1 to 7 described above.

The memory 810 may store various programs related to the operations of the battery diagnostic device 10. In addition, the memory 810 may store operating data of the battery diagnostic device 10.

A plurality of memories 810 may be provided as needed. The memory 810 may be a volatile memory or non-volatile memory. As the volatile memory, the memory 810 may be a random access memory (RAM), dynamic RAM (DRAM), static RAM (SRAM), or the like. As the nonvolatile memory, for the memory 810, a read-only memory (ROM), a programmable ROM (PROM), an electrically alterable ROM (EAROM), an erasable programmable ROM (EPROM), an electrically erasable programmable ROM (EEPROM), a flash memory, or the like. The examples of memories 810 listed above are only exemplary and are not limited to the examples.

The input/output I/F 820 may provide an interface that connects an input device (not shown) such as a keyboard, a mouse, a touch panel, or the like, and an output device such as a display (not shown), to the MCU 800 to enable data transmission and reception.

The communication I/F 830 is a component that may transmit and receive various data to and from the server, and may be any device that may support wired or wireless communication. For example, a program for abnormal diagnosis or various data may be transmitted to and received from a separately provided external server through the communication I/F 830.

Terms such as "include," "comprise," or "have" described above mean that the corresponding component may be present unless otherwise stated, and thus it should be construed that other components may be further included rather than excluding other components. All terms including technical or scientific terms have the same meaning as commonly understood by those of ordinary skill in the art to which embodiments disclosed herein belong, unless otherwise defined. Terms commonly used such as those defined in dictionaries should be interpreted as having a meaning that is consistent with their meaning in the context of the related art and will not be interpreted in an idealized or overly formal sense unless expressly so defined herein.

The above description is merely an example of the technical idea disclosed herein, and those with ordinary skill in the art to which the embodiments disclosed herein belong may make various modifications and variations without departing from the essential characteristics of the embodiments disclosed herein. Accordingly, the embodiments disclosed herein are not intended to limit the technical ideas of the embodiments disclosed herein but rather to explain them, and the scope of the technical ideas disclosed herein is not limited by these embodiments. The scope of protection disclosed herein should be interpreted by the accompanying claims, and all technical ideas within the scope equivalent thereto should be construed as being included in the scope of rights herein.

## Claims

1. A battery diagnostic device comprising:
an interface configured to acquire a voltage value of each of battery cells; and
one or more controllers configured to:
calculate an average voltage value of the battery cells;
calculate a cell voltage deviation of each of the battery cells based on the average voltage value;
generate diagnostic data related to the cell voltage deviation according to the average voltage value for each of the battery cells; and
diagnose a state of the battery cells based on the cell voltage deviation in a diagnostic section in which an amount of change in the cell voltage deviation of the diagnostic data corresponds to a specified condition.

2. The battery diagnostic device of claim 1, wherein the controller diagnoses, as a low-voltage cell, a battery cell for which the cell voltage deviation is less than or equal to a first threshold value.

3. The battery diagnostic device of claim 1, wherein the controller diagnoses a battery cell for which a slope value between cell voltage deviations according to at least two average voltage values is greater than or equal to a second threshold value as an abnormal capacity cell.

4. The battery diagnostic device of claim 1, wherein the controller diagnoses a battery cell for which a change in a slope of cell voltage deviations according to at least two average voltage values included in the diagnostic section is outside a threshold range as an abnormal behavior cell.

5. The battery diagnostic device of claim 1, wherein the voltage value is a voltage value acquired during a process of charging the battery cells.

6. The battery diagnostic device of claim 1, wherein the battery cells are included in one or more battery modules, and
the controller calculates an average voltage value for each battery module based on voltage values of the battery cells included in the same battery module and calculates the cell voltage deviation of each of the battery cells based on the average voltage value for each battery module.

7. The battery diagnostic device of claim 1, wherein the specified condition includes a condition in which a change in an amount of change in the cell voltage deviation corresponds to linearity.

8. A method of operating a battery diagnostic device, comprising:
acquiring a voltage value of each of battery cells;
calculating an average voltage value of the battery cells;
calculating a cell voltage deviation of each of the battery cells based on the average voltage value;
generating diagnostic data related to the cell voltage deviation according to the average voltage value for each of the battery cells; and
diagnosing a state of the battery cells based on the cell voltage deviation in a diagnostic section in which an amount of change in the cell voltage deviation of the diagnostic data corresponds to a specified condition.

9. The method of claim 8, wherein the diagnosing includes diagnosing, as a low-voltage cell, a battery cell for a cell voltage deviation is less than or equal to a first threshold value.

10. The method of claim 8, wherein the diagnosing includes diagnosing a battery cell for which a slope value between cell voltage deviations according to at least two average voltage values is greater than or equal to a second threshold value as an abnormal capacity cell.

11. The method of claim 8, wherein the diagnosing includes diagnosing a battery cell for which a change in a slope of cell voltage deviations according to at least two average voltage values included in the diagnostic section is outside a threshold range as an abnormal behavior battery cell.

12. The method of claim 8, wherein the voltage value is a voltage value acquired during a process of charging the battery cells.

13. The method of claim 8, wherein the battery cells are included in one or more battery modules, and
the calculating includes:
calculating an average voltage value for each battery module based on voltage values of the battery cells included in the same battery module; and
calculating the cell voltage deviation of each of the battery cells based on the average voltage value for each battery module.

14. The method of claim 8, wherein the specified condition includes a condition in which a change in an amount of change in the cell voltage deviation corresponds to linearity.
